# FASCICULE DE BREVET EUROPEEN

(11) **EP 3 100 034 B1**
(45) Date de publication et mention de la délivrance du brevet: **31.01.2018**
(21) Numéro de dépôt: 14790524.4
(22) Date de dépôt: 07.10.2014
(51) Int. Cl.: G01N 23/225, H01J 37/244, H01J 37/295, G02B 26/08

(54) **PROCEDE ET DISPOSITIF POUR ACQUERIR ET TRAITER DES DIAGRAMMES DE DIFFRACTION ISSUS D'UN EQUIPEMENT METTANT EN OEUVRE UN FAISCEAU DE PARTICULES FOCALISEES, ET SYSTEME D'IMAGERIE ANALYTIQUE INTEGRANT CE DISPOSITIF**
VERFAHREN UND VORRICHTUNG ZUR ERFASSUNG UND VERARBEITUNG VON BEUGUNGSMUSTERN ERZEUGT IN EINER APPARATUR MIT EINEM FOKUSSIERTEN PARTIKELSTRAHL UND ANALYTISCHES BILDGEBUNGSSYSTEM MIT DIESER VORRICHTUNG
METHOD AND DEVICE FOR ACQUIRING AND PROCESSING DIFFRACTION DIAGRAMS FROM A PIECE OF EQUIPMENT WHICH USES A FOCUSED-PARTICLE BEAM, AND AN ANALYTICAL IMAGING SYSTEM INCLUDING SAID DEVICE

(30) Priorité: 30.01.2014 FR 1450730
(43) Date de publication de la demande: 07.12.2016
(73) Titulaire: Newtec Scientific, 30900 Nimes (FR)
(72) Inventeur: MENARD, Jean-Claude, F-78390 Bois d'Arcy (FR)
(74) Mandataire: Pontet Allano & Associes
(86) Numéro de dépôt international: PCT/EP2014/071392
(87) Numéro de publication internationale: WO 2015/113658

(56) Documents cités:
- US-A1- 2003 198 272
- STEVEN P. LOVE ET AL: "Full-frame programmable spectral filters based on micromirror arrays", JOURNAL OF MICRO/NANOLITHOGRAPHY, MEMS AND MOEMS, vol. 13, no. 1, 2 janvier 2014 (2014-01-02), page 011108, XP055131871, ISSN: 1932-5150, DOI: 10.1117/1.JMM.13.1.011108

## Description

### Domaine technique

La présente invention concerne un procédé pour traiter des diagrammes de diffraction produits par un équipement mettant en oeuvre un faisceau de particules focalisées, tel qu'un microscope électronique à balayage. Elle concerne également un dispositif de traitement mettant en oeuvre ce procédé, ainsi qu'un système d'imagerie analytique intégrant ce dispositif de traitement.

Le domaine de l'invention est, de manière non limitative, celui de l'analyse des microstructures par mesure de la diffraction des ions, des électrons et/ou des photons.

### Etat de la technique antérieure

Les techniques de diffraction par ondes et par particules chargées (rayonnement X, électrons, ions...) permettent la détermination de l'arrangement cristallographique des matériaux en phase solide. La maîtrise des procédés de fabrication et d'identification des matériaux monocristallins et poly-cristallins est aujourd'hui un enjeu important pour l'élaboration et l'expertise de produits industriels modernes.

L'arrangement cristallographique d'un échantillon peut être déterminé par l'analyse de clichés de diffraction s'opérant par rétrodiffusions ou transmissions d'ondes ou de particules chargées issues d'une émission primaire sur le matériau cristallin étudié. Cette diffraction d'ondes ou particules obéit à la loi bien connue de diffraction de Bragg.

On peut notamment citer des techniques relevant du domaine de la microscopie électronique à balayage, de diffraction d'électrons rétrodiffusés EBSD (Electron Back Scattered Diffraction), de diffraction d'électrons transmis ETD (Electron Transmission Diffraction), ainsi que des techniques de microscopie par imagerie d'orientation OIM (Orientation Imaging Microscopy).

Le principe général en est le suivant. La surface du matériau à analyser est balayée par un faisceau d'électrons. Les électrons diffractés sont dirigés vers un convertisseur optique tel qu'un écran phosphorescent au contact duquel ils génèrent des photons, phénomène appelé cathodoluminescence. Pour chaque position du faisceau d'électrons sur la surface du matériau à analyser, on obtient ainsi un diagramme de diffraction sur le convertisseur optique. Cette image de diffraction est ensuite ré-imagée sur un détecteur matriciel quelconque (CCD refroidi par exemple) pour être numérisée.

En balayant toute la surface du matériau, on obtient ainsi une pile d'images de diffraction dont l'analyse permet de déterminer la structure locale et l'orientation cristalline du matériau.

Le problème qui se pose est qu'il faut analyser un grand nombre d'images et identifier dans chacune d'elles des structures complexes (telles que les lignes de Kikuchi ou cônes de Kossel), ce qui demande des ressources informatiques considérables et nécessite des temps de calcul importants.

La présente invention a pour objet de proposer un procédé et un dispositif d'acquisition et de traitement de diagrammes de diffraction plus rapide et moins consommateur en ressources de calcul que ceux de l'art antérieur.

Un dispositif d'acquisition et de traitement de diagrammes de diffraction est décrit dans US2003198272 A1. La présente invention a également pour objet de proposer un tel procédé et un tel dispositif qui soit aisément adaptable à une grande variété de configurations de structures de diffraction.

### Exposé de l'invention

Ces objectifs sont atteints avec un procédé pour traiter des diagrammes de diffraction issus d'un équipement mettant en oeuvre un faisceau de particules focalisés, lesquels diagrammes de diffraction étant respectivement générés par un écran convertisseur particules-photons sensible à des particules diffractées par un matériau à analyser par ledit équipement, pour une position d'un faisceau primaire de particules sur la surface dudit matériau,
caractérisé en ce que qu'il comprend :
- une transmission sélective vers un photodétecteur, au moyen d'un modulateur spatial de lumière, de la lumière émise depuis ledit écran convertisseur dans au moins une zone sélectionnée, laquelle lumière ayant une intensité photonique représentative des caractéristiques de diffraction du matériau dans ladite zone sélectionnée,
- une détection, au moyen dudit photodétecteur, d'une intensité photonique représentative de la lumière transmise par ledit modulateur spatial de lumière, et
- une programmation dudit modulateur spatial de lumière selon un diagramme filtre pour réaliser une fonction de filtrage spatial de la lumière issue dudit écran convertisseur.

Le procédé selon l'invention peut notamment être utilisé pour traiter des diagrammes de diffraction issus d'un équipement mettant en oeuvre un faisceau d'électrons focalisés, tel qu'un microscope électronique à balayage.

Suivant des modes de mise en oeuvre, le procédé selon l'invention peut comprendre la programmation d'un diagramme filtre correspondant à une sélection d'une zone de l'écran convertisseur.

Suivant des modes de mise en oeuvre, le procédé selon l'invention peut comprendre la programmation d'un diagramme filtre correspondant à un diagramme de diffraction de référence.

Ce diagramme de diffraction de référence peut notamment être un diagramme de diffraction généré par un matériau de référence.

Le procédé selon l'invention peut comprendre en outre une acquisition d'un diagramme de diffraction de référence pour une position d'un faisceau primaire de particules sur la surface du matériau, avec une programmation séquentielle d'une pluralité de diagrammes filtres correspondant chacun à une zone de l'écran convertisseur, de sorte à détecter séquentiellement les intensités photoniques correspondant aux différentes zones dudit diagramme de diffraction de référence.

Suivant des modes de mise en oeuvre, le procédé selon l'invention peut comprendre en outre :
- un balayage du matériau par le faisceau primaire de façon à produire sur l'écran convertisseur un ensemble de diagrammes de diffraction, désignés sous le terme de Diagrammes Individus, correspondant respectivement à des points de balayage dudit faisceau primaire, et
- pour chaque point de balayage, une génération d'un signal correspondant à l'intensité photonique détectée, dont le niveau est fonction du degré de corrélation entre le diagramme filtre programmé et le diagramme individu correspondant audit point de balayage.

Il est possible de mettre en oeuvre, par exemple :
- un seul diagramme filtre pour tous les points de balayage du faisceau primaire ;
- plusieurs diagrammes filtres choisis notamment en fonction du point de balayage du faisceau primaire ;
- un diagramme filtre différent pour chaque point de balayage du faisceau primaire.

Le procédé selon l'invention peut comprendre en outre une production, à partir des signaux générés, d'une image constituant une cartographie spatiale de l'orientation cristallographique du matériau.

Suivant des modes de réalisation de l'invention, le procédé selon l'invention peut être mis en oeuvre dans l'une quelconque des configurations suivantes :
- avec un convertisseur particules-photons situé face à un échantillon de matériau à analyser de sorte que les particules interceptées sont celles rétrodiffusées par ledit échantillon;
- avec un convertisseur particules-photons situé derrière un échantillon de matériau à analyser de sorte que les particules interceptées sont celles transmises au travers dudit échantillon.

Un avantage majeur du procédé de traitement selon l'invention réside dans le fait qu'il procure un gain de temps de calcul par rapport à une analyse complète des images de diffraction. Il permet aussi d'analyser qualitativement les défauts structuraux et microstructuraux (contraintes résiduelles à l'échelle locale) mais également d'observer en temps réel l'évolution de la cristallographie lors de tests dynamiques in-situ, c'est-à-dire lors d'essais mécaniques (traction, compression, cisaillement, torsion,...) et d'essais thermiques (fusion, recristallisation,...) ou la combinaison de ces deux types d'essais.

Suivant un autre aspect de l'invention, il est proposé un dispositif pour traiter des diagrammes de diffraction issus d'un équipement mettant en oeuvre un faisceau d'électrons focalisé, lesquels diagrammes de diffraction étant respectivement générés par un écran convertisseur particules-photons sensible à des particules diffractées par un matériau à analyser par ledit équipement pour une position d'un faisceau primaire de particules sur la surface dudit matériau, lequel dispositif comprenant :
- un modulateur spatial de lumière, apte à transmettre sélectivement vers un photo-détecteur la lumière émise depuis ledit écran convertisseur dans au moins une zone sélectionnée, laquelle lumière ayant une intensité photonique représentative des caractéristiques de diffraction du matériau dans ladite zone sélectionnée,
- un photo-détecteur apte à détecter une intensité photonique représentative de la lumière transmise par ledit modulateur spatial de lumière,
- des moyens de programmation dudit modulateur spatial de lumière selon un diagramme filtre pour réaliser une fonction de filtrage spatial de la lumière issue dudit écran convertisseur.

Suivant des modes de réalisation, le dispositif selon l'invention peut comprendre un modulateur spatial de lumière avec une matrice de cellules solides ou à cristaux liquides aptes à bloquer ou à transmettre la lumière en fonction d'un signal de commande.

De tels composants comprennent en général une couche de cristaux liquides ou solides divisée en cellules adressables ou commandables individuellement, et placée entre deux polariseurs. La lumière incidente sur une cellule est polarisée par le premier polariseur, puis sa polarisation est modifiée par la couche de cristaux liquides ou solides, d'une façon qui dépend du signal de commande. Si elle arrive sur le deuxième polariseur avec une polarisation parallèle à l'axe de ce dernier elle peut sortir de la cellule et être transmise. Dans le cas contraire elle est bloquée et la cellule est opaque.

Suivant des modes de réalisation, le dispositif selon l'invention peut comprendre un modulateur spatial de lumière avec au moins un miroir adressable en déviation angulaire, de sorte à pouvoir être orienté au moins selon un angle de transmission vers le photo-détecteur.

Le dispositif selon l'invention peut notamment comprendre un modulateur spatial de lumière :
- avec un miroir orientable sur deux axes ;
- avec une matrice de miroirs adressables individuellement en déviation angulaire, de sorte à pouvoir être orientés au moins selon l'angle de transmission vers le photo-détecteur ;
- de type bistable, avec une matrice de miroirs adressables individuellement en déviation angulaire d'une amplitude correspondant respectivement à l'angle de transmission vers le photo-détecteur et à son opposé.

Le modulateur spatial de lumière peut comprendre en outre un prisme à réflexion totale ou partielle disposé en regard du ou des miroir(s) et agencé de telle sorte à transmettre vers le photodétecteur uniquement la lumière renvoyée par le ou les miroir(s) adressable(s) orienté(s) selon l'angle de transmission.

Cet angle de transmission correspond donc à un angle d'orientation des miroirs pour lequel on remplit la condition de réflexion totale sur le prisme.

Le dispositif selon l'invention peut comprendre en outre :
- en aval du modulateur spatial de lumière, un dispositif optique de concentration de photons disposé pour recevoir les rayons réfléchis issus dudit modulateur spatial selon l'angle de transmission ;
- en aval du dispositif de concentration de photons, un tunnel à lumière.

Le dispositif selon l'invention peut comprendre en outre :
- des moyens pour balayer le matériau avec le faisceau primaire de façon à produire sur l'écran convertisseur un ensemble de diagrammes de diffraction, désignés sous le terme de diagrammes Individu, correspondant respectivement à des points de balayage dudit faisceau primaire ;
- des moyens pour produire, à partir des signaux issus du photo-détecteur et correspondant aux points de balayage du faisceau primaire, une image constituant une cartographie spatiale de l'orientation cristallographique du matériau.

Suivant des modes de réalisation, le dispositif selon l'invention peut être couplé à l'un des équipements suivants :
- équipement de microscopie électronique à balayage en mode de rétrodiffusion,
- équipement de microscopie électronique à balayage en mode de transmission,
- équipement générateur d'électrons focalisés,
- équipement générateur d'ions focalisés.

Suivant un autre aspect, il est proposé un système d'imagerie analytique comprenant un équipement mettant en oeuvre un faisceau de particules focalisées équipé d'un dispositif de traitement de diagrammes de diffraction selon l'invention.

### Description des figures et modes de réalisation

D'autres avantages et particularités de l'invention apparaîtront à la lecture de la description détaillée de mises en oeuvre et de modes de réalisation nullement limitatifs, et des dessins annexés suivants :
- la Fig. 1 illustre un exemple d'un dispositif d'imagerie analytique selon l'invention ;
- la Fig. 2 illustre un composant DMD ou MEMS mis en oeuvre dans le dispositif de la figure 1 ;
- la Fig. 3 représente un mode de fonctionnement du composant de la Fig. 2 ;
- la Fig. 4 illustre un diagramme de diffraction obtenu avec le procédé d'imagerie analytique selon l'invention ;
- la Fig. 5 illustre graphiquement comment un niveau de signal est généré avec le procédé selon l'invention ; et
- la Fig. 6 représente une image constituant une cartographie spatiale de l'orientation cristallographique d'un matériau analysé avec le procédé selon l'invention.

Ces modes de réalisation étant nullement limitatifs, on pourra notamment considérer des variantes de l'invention ne comprenant qu'une sélection de caractéristiques décrites par la suite isolées des autres caractéristiques décrites (même si cette sélection est isolée au sein d'une phrase comprenant ces autres caractéristiques), si cette sélection de caractéristiques est suffisante pour conférer un avantage technique ou pour différencier l'invention par rapport à l'état de la technique antérieure. Cette sélection comprend au moins une caractéristique de préférence fonctionnelle sans détails structurels, ou avec seulement une partie des détails structurels si cette partie uniquement est suffisante pour conférer un avantage technique ou à différencier l'invention par rapport à l'état de la technique antérieure. Sur les figures un élément apparaissant sur plusieurs figures conserve la même référence.

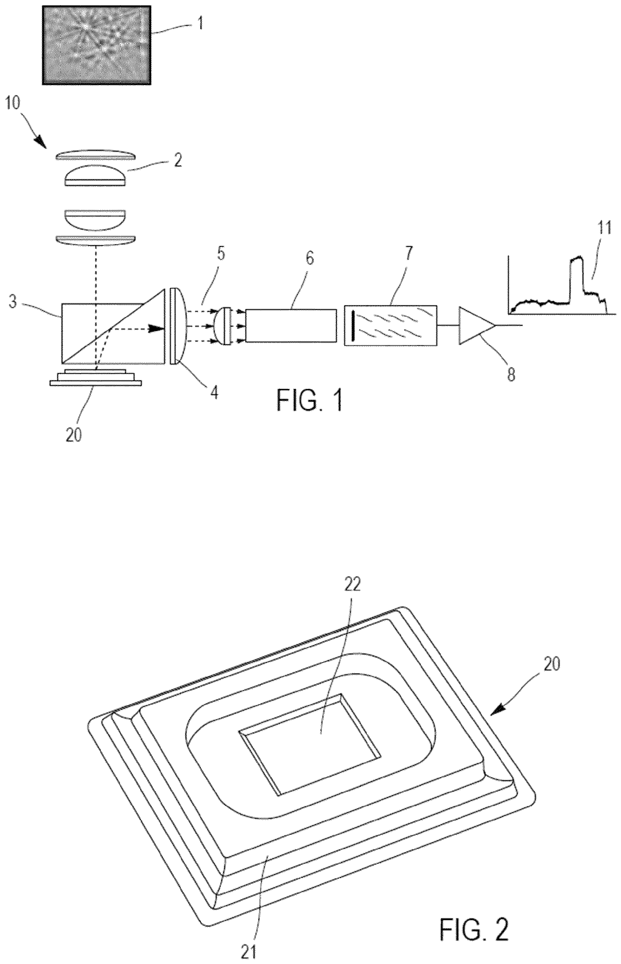

On va maintenant décrire, en référence aux Fig. 1 à 3, un exemple de réalisation d'un dispositif de traitement de diagrammes de diffraction selon l'invention, en même temps que le procédé mis en oeuvre dans ce dispositif.

Dans le mode de réalisation présenté, ce dispositif est mis en oeuvre dans un microscope électronique à balayage, utilisé en rétrodiffusion. Dans un tel système, un faisceau d'électrons primaires est focalisé sur une surface d'un matériau ou d'un échantillon à analyser, au moins en un point ou une position. Des électrons secondaires porteurs d'une information de diffraction sont ainsi générés.

Le dispositif de traitement 10 selon l'invention comprend un écran 1 phosphorescent utilisé comme convertisseur d'électrons en photons. Cet écran-convertisseur 1 est placé de telle sorte à recevoir les électrons secondaires (rétrodiffusés) issus de la diffraction du faisceau d'électrons primaires sur le matériau. Pour chaque position du faisceau d'électrons primaires sur le matériau, on obtient ainsi sur l'écran-convertisseur 1 un diagramme de diffraction.

Le dispositif selon l'invention comprend également une optique d'adaptation 2, un prisme à réflexion totale 3, un modulateur spatial de lumière bistable programmable 20, un dispositif optique de concentration de photons 4, un tunnel à lumière ou un guide de lumière 6 et un photo-détecteur à gain variable 7 (tel qu'une photodiode à avalanche ou un photomultiplicateur, éventuellement refroidi).

L'optique d'adaptation 2 permet de collecter l'image générée par phosphorescence ou fluorescence sur l'écran-convertisseur 1 pour la transporter sur le modulateur spatial de lumière 20.

Le modulateur spatial de lumière 20 comprend, en référence à la Fig. 2, au sein d'un boîtier 21, une matrice 22 de micro-miroirs microscopiques adressables individuellement en déviation angulaire d'une amplitude de +/-12°. Ce composant de type DMD (Digital Micro Mirror Device = Dispositif à micro-miroirs numérique) peut être issu par exemple de la technologie DLP (Digital Light Processing = Traitement numérique de lumière) de la firme Texas Instruments Inc.

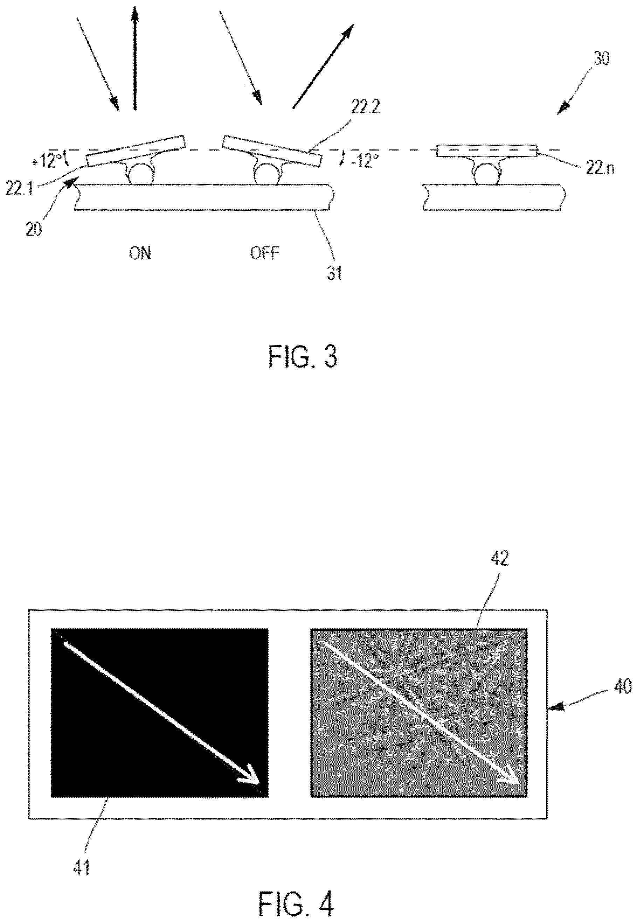

Le modulateur spatial 20 se comporte comme un réflecteur sélectif 30 où chaque pixel miroir 22.1, 22.2,...22.n de sa matrice, disposé sur un substrat silicium 31, peut prendre deux orientations différentes, en référence à la Fig. 3 : soit il réfléchit la lumière d'une source vers un chemin optique (déviation de +12°), soit il réfléchit cette même source vers une surface qui en absorbe les rayons (déviation de -12°) et donc hors du chemin optique utilisé. Les rayons 5 réfléchis vers le chemin optique (déviation de +12°) sont alors concentrés par le dispositif concentrateur d'image 4.

Le prisme à réflexion totale 3 assure le transfert de la lumière vers le dispositif concentrateur d'image 4. Il comprend une interface qui permet une transmission vers le modulateur spatial 20 de la lumière issue de l'écran-convertisseur 1 et une réflexion des rayons 5 réfléchis vers le chemin optique. Cet effet est obtenu grâce à la différence d'angles d'incidences de ces faisceaux respectifs sur l'interface.

A ce point, la lumière est transportée via le tunnel à lumière 6 puis collectée par le photo-détecteur 7. Ce photo-détecteur 7 est relié à une électronique de traitement 8 qui délivre un signal de mesure 11 proportionnel à l'intensité optique en entrée du photo-détecteur.

L'écran convertisseur 1 est imagé sur la matrice 22 de micro-miroirs par l'optique d'adaptation 2. Le modulateur spatial 20 permet ainsi de sélectionner les zones du diagramme de diffraction dont la lumière est transmise vers le photo-détecteur 7. Il se comporte ainsi comme un filtre spatial.

Le niveau du signal de mesure issu du photo-détecteur 7 est représentatif de l'intensité du diagramme de diffraction obtenu sur l'écran-convertisseur 1 dans la ou les zones sélectionnées par le modulateur spatial de lumière 20.

Il est à noter que si une seule zone de l'écran-convertisseur 1 est sélectionnée (en activant par exemple un seul micro-miroir de la matrice 22 ou un seul groupe de micro-miroirs contigus), le signal de mesure issu du photo-détecteur 7 est représentatif de la diffraction dans cette zone du diagramme de diffraction.

Par contre, si plusieurs zones de l'écran-convertisseur 1 sont sélectionnées simultanément (en activant par exemple plusieurs micro-miroirs distants de la matrice 22), le signal de mesure issu du photo-détecteur 7 est représentatif de la somme des intensités de diffraction dans ces différentes zones du diagramme de diffraction.

La configuration des miroirs de la matrice 22 réalise ainsi un diagramme-filtre, qui peut bien entendu être modifié à volonté par programmation de la matrice 22. Mathématiquement, ce diagramme-filtre peut être représenté par une matrice ou un masque bidimensionnel de zéros et de uns correspondant respectivement aux états bloqués / passants des micro-miroirs.

Le signal de mesure issu du détecteur 7 est donc fonction d'une somme des produits des intensités lumineuses du diagramme de diffraction présent sur l'écran-convertisseur 1 avec le diagramme-filtre. On peut ainsi considérer qu'il est représentatif d'une mesure de corrélation ou de distance entre le diagramme de diffraction individu et le diagramme-filtre.

En référence au schéma 40 de la Fig. 4, le dispositif de traitement 10 permet la reconstitution d'un diagramme de diffraction 42 complet, par programmation sélective et séquentielle du modulateur spatial de lumière 20.

Le faisceau d'électrons primaire est maintenu statique en une position déterminée de l'échantillon, correspondant à une orientation cristalline du matériau. Les pixel-miroirs (ou des groupes de pixels miroirs contigus) de la matrice sont activés séquentiellement, de sorte à transmettre séquentiellement vers le photo-détecteur 7 l'intensité lumineuse correspondant aux différentes parties du diagramme de diffraction. Comme on connaît la position dans la matrice 22 des micro-miroirs activés pour obtenir les mesures, et que ces micro-miroirs correspondent à des zones connues de l'écran-convertisseur 1, on peut ainsi reconstruire le diagramme de diffraction 42.

Ce diagramme 42 permet de déterminer l'orientation 41 du matériau selon les données cristallographiques (par exemple plans et indices de Miller) par les méthodes de détection usuelles utilisées en cristallographie.

Ainsi, l'invention permet d'obtenir un diagramme de diffraction 42 complet avec un photo-détecteur ponctuel 7 de très haute sensibilité mais de coût très inférieur à celui d'une caméra CCD refroidie.

En pratique, ce mode de fonctionnement permet surtout d'obtenir un diagramme-filtre représentatif d'une configuration ou d'une orientation cristalline de référence du matériau, afin d'obtenir une image de la surface de ce matériau dans laquelle l'orientation cristalline (par rapport à une orientation cristalline de référence) est codée en intensité.

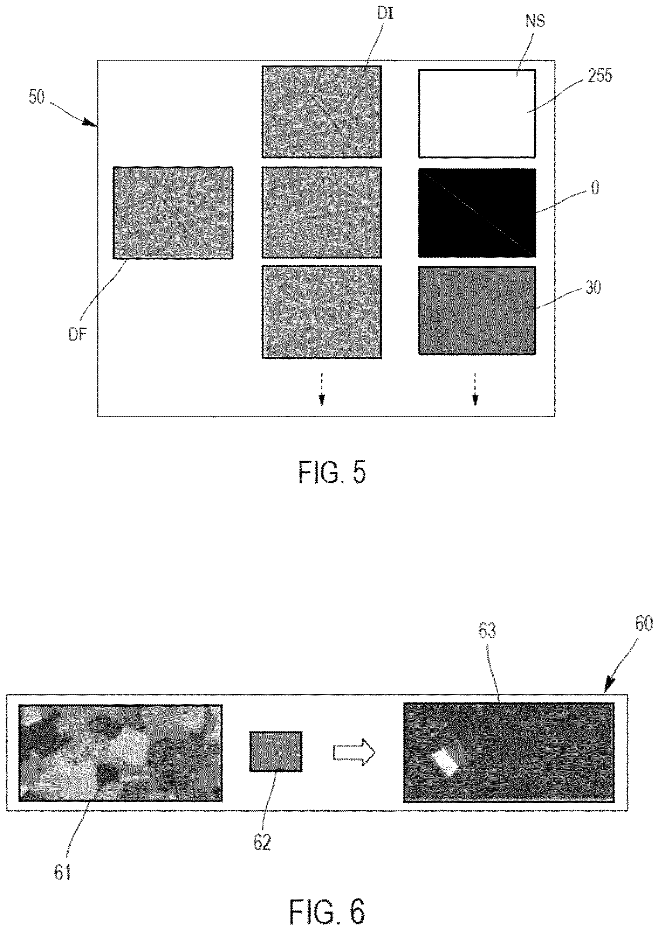

Pour cela, un diagramme de diffraction préalablement acquis est programmé dans le modulateur spatial 20 et utilisé comme un diagramme Filtre DF, en référence à la représentation graphique 50 de la figure 5. La configuration des miroirs de la matrice 22 est ajustée de telle sorte à reproduire avec les miroirs actifs des motifs caractéristiques (de plus forte intensité de diffraction par exemple) du diagramme de diffraction utilisé comme référence (bandes de Kikuchi, cônes de Kossel,...).

Le matériau à analyser est alors balayé par un faisceau d'électrons primaires focalisés.

Pour chaque position du faisceau primaire, un diagramme de diffraction apparaît sur l'écran-convertisseur 1. On désigne ces diagrammes de diffraction sous le nom de diagrammes Individu DI.

Le signal de mesure NS généré par le photo-détecteur 7 dépend du degré de corrélation entre le diagramme Individu DI correspondant et le diagramme Filtre DF appliqué sur le modulateur spatial 20.

Connaissant la position du faisceau d'électrons primaire sur le matériau, on peut ainsi recréer une image de ce matériau dont l'amplitude (traduite par exemple en couleurs ou en niveaux de gris) est représentative du signal de mesure NS.

Le principe de filtrage de l'invention et ses résultats sont illustrés par le schéma 60 de la Fig. 6.

L'image non filtrée 61 illustre la surface du matériau avec toutes les orientations cristallographiques visibles.

Des mesures de diffraction sont réalisées sur la surface de ce matériau avec un dispositif selon l'invention. Un diagramme Filtre DF 62 qui correspond à une orientation cristallographique particulière est utilisé. On obtient ainsi une image filtrée 63 dans laquelle les zones dont les orientations cristallographiques diffèrent de celle correspondant au diagramme Filtre DF 62 sont immédiatement contrastées..

Ainsi, sur une région de l'échantillon de matériau balayée, le dispositif de traitement 10 est capable de révéler la présence de grains, et de discriminer l'ensemble des défauts cristallins (macles, écrouissage, formations de joints et sous-joints, dislocations,...). Ces informations, qui sont représentées sous forme d'une image, constituent une cartographie spatiale de l'orientation cristallographique du matériau.

Il est à noter que l'image filtrée 63 peut être obtenue en temps réel, au fur et à mesure que la surface du matériau est balayée par le faisceau d'électrons primaire. Contrairement à l'état de l'art existant, elle ne nécessite aucun traitement particulier en aval de la part de processeurs arithmétiques, le motif programmé sur la matrice du modulateur spatial assurant cette fonction de filtre en amont.

Des diagrammes filtre de toute sorte peuvent être mis en oeuvre avec l'invention. En particulier,
- ils peuvent être générés à partir de mesures comme expliqué précédemment ;
- ils peuvent être déterminés mathématiquement ;
- ils peuvent ne comprendre qu'une seule zone continue active (point, ligne, courbes, forme particulières) ;
- ils peuvent comprendre plusieurs zones actives distinctes.

Le dispositif de traitement selon l'invention peut être prévu pour traiter des images de diffraction issues soit de particules rétrodiffusées, soit de particules transmises, selon la géométrie du convertisseur particules-photons qui est situé face à l'échantillon pour la rétrodiffusion, ou en dessous de l'échantillon pour la transmission. Ce dispositif de traitement, couplé à un microscope électronique à balayage du type à rétrodiffusion ou à transmission, constitue un système d'imagerie analytique.

## Revendications

1. Procédé pour traiter des diagrammes de diffraction issus d'un équipement mettant en oeuvre un faisceau de particules focalisées, lesquels diagrammes de diffraction étant respectivement générés par un écran convertisseur particules-photons (1) sensible à des particules diffractées par un matériau à analyser par ledit équipement, pour une position d'un faisceau primaire de particules sur la surface dudit matériau,
**caractérisé en ce que** qu'il comprend :
- une transmission sélective vers un photodétecteur (7), au moyen d'un modulateur spatial de lumière (20), de la lumière émise depuis ledit écran convertisseur (1) dans au moins une zone sélectionnée, laquelle lumière ayant une intensité photonique représentative des caractéristiques de diffraction du matériau dans ladite zone sélectionnée,
- une détection, au moyen dudit photodétecteur (7), d'une intensité photonique représentative de la lumière transmise par ledit modulateur spatial de lumière (20), et
- une programmation dudit modulateur spatial de lumière (20) selon un diagramme filtre (DF) pour réaliser une fonction de filtrage spatial de la lumière issue dudit écran convertisseur (1).

2. Le procédé de la revendication 1, qui comprend la programmation d'un diagramme filtre (DF) correspondant à une sélection d'une zone de l'écran convertisseur (1).

3. Le procédé de la revendication 1, qui comprend la programmation d'un diagramme filtre (DF) correspondant à un diagramme de diffraction de référence.

4. le procédé de la revendication 3, qui comprend en outre une acquisition d'un diagramme de diffraction de référence pour une position d'un faisceau primaire de particules sur la surface du matériau, avec une programmation séquentielle d'une pluralité de diagrammes filtres (DF) correspondant chacun à une zone de l'écran convertisseur (1), de sorte à détecter séquentiellement les intensités photoniques correspondant aux différentes zones dudit diagramme de diffraction de référence.

5. le procédé de l'une des revendications précédentes, qui comprend en outre :
- un balayage du matériau par le faisceau primaire de façon à produire sur l'écran convertisseur (1) un ensemble de diagrammes de diffraction, désignés sous le terme de diagrammes Individu (DI), correspondant respectivement à des points de balayage dudit faisceau primaire, et
- pour chaque point de balayage, une génération d'un signal correspondant à l'intensité photonique détectée, dont le niveau est fonction du degré de corrélation entre le diagramme filtre (DF) programmé et le diagramme Individu (DI) correspondant audit point de balayage.

6. Le procédé de la revendication 5, qui comprend en outre une production, à partir des signaux générés, d'une image (63) constituant une cartographie spatiale de l'orientation cristallographique du matériau.

7. Le procédé de l'une quelconque des revendications précédentes, qui est mis en oeuvre dans l'une quelconque des configurations suivantes :
- avec un convertisseur particules-photons situé face à un échantillon de matériau à analyser de sorte que les particules interceptées sont celles rétrodiffusées par ledit échantillon;
- avec un convertisseur particules-photons situé derrière un échantillon de matériau à analyser de sorte que les particules interceptées sont celles transmises au travers dudit échantillon.

8. Dispositif (10) pour traiter des diagrammes de diffraction issus d'un équipement mettant en oeuvre un faisceau de particules focalisées, lesquels diagrammes de diffraction étant respectivement générés par un écran convertisseur particules-photons (1) sensible à des particules diffractées par un matériau à analyser par ledit équipement pour une position d'un faisceau primaire de particules sur la surface dudit matériau, **caractérisé en ce qu'**il comprend :
- un modulateur spatial de lumière (20), apte à transmettre sélectivement vers un photo-détecteur (7) la lumière émise depuis ledit écran convertisseur (1) dans au moins une zone sélectionnée, laquelle lumière ayant une intensité photonique représentative des caractéristiques de diffraction du matériau dans ladite zone sélectionnée,
- un photo-détecteur (7) apte à détecter une intensité photonique représentative de la lumière transmise par ledit modulateur spatial de lumière (20),
- des moyens de programmation dudit modulateur spatial de lumière (20) selon un diagramme filtre (DF) pour réaliser une fonction de filtrage spatial de la lumière issue dudit écran convertisseur (1).

9. Le dispositif de la revendication 8, qui comprend un modulateur spatial de lumière avec une matrice de cellules solides ou à cristaux liquides aptes à bloquer ou à transmettre la lumière en fonction d'un signal de commande.

10. Le dispositif de la revendication 8, qui comprend un modulateur spatial de lumière (20) avec au moins un miroir adressable (22) en déviation angulaire, de sorte à pouvoir être orienté au moins selon un angle de transmission vers le photo-détecteur.

11. le dispositif de la revendication 10, qui comprend un modulateur spatial de lumière (20) de type bistable, avec une matrice (22) de miroirs adressables individuellement en déviation angulaire d'une amplitude correspondant respectivement à l'angle de transmission vers le photo-détecteur et à son opposé.

12. Le dispositif de l'une des revendications 10 ou 11, dans lequel le modulateur spatial de lumière (20) comprend en outre un prisme (3) à réflexion totale ou partielle disposé en regard du ou des miroir(s) (22) et agencé de telle sorte à transmettre vers le photo-détecteur (7) uniquement la lumière renvoyée par le ou les miroir(s) adressable(s) (22) orienté(s) selon l'angle de transmission.

13. Le dispositif de l'une des revendications 10 à 12, qui comprend en outre, en aval du modulateur spatial de lumière (20), un dispositif optique de concentration de photons (4) disposé pour recevoir les rayons réfléchis issus dudit modulateur spatial selon l'angle de transmission.

14. le dispositif de la revendication 13, qui comprend en outre, en aval du dispositif de concentration de photons, un tunnel à lumière (6).

15. Le dispositif de l'une des revendications 8 à 14, qui comprend en outre des moyens pour balayer le matériau avec le faisceau primaire de façon à produire sur l'écran convertisseur (1) un ensemble de diagrammes de diffraction, désignés sous le terme de Diagrammes Individu (DI), correspondant respectivement à des points de balayage dudit faisceau primaire.

16. Le dispositif de la revendication 15, qui comprend en outre des moyens pour produire, à partir des signaux issus du photo-détecteur (7) et correspondant aux points de balayage du faisceau primaire, une image (63) constituant une cartographie spatiale de l'orientation cristallographique du matériau.

17. Le dispositif de l'une quelconque des revendications 8 à 16, qui est couplé à l'un des équipements suivants :
- équipement de microscopie électronique à balayage en mode de rétrodiffusion,
- équipement de microscopie électronique à balayage en mode de transmission,
- équipement générateur d'électrons focalisés.
- équipement générateur d'ions focalisés

18. Système d'imagerie analytique comprenant un équipement mettant en oeuvre un faisceau de particules focalisées équipé d'un dispositif de traitement de diagrammes de diffraction selon l'une quelconque des revendications 8 à 17.

## Patentansprüche

1. Verfahren zur Verarbeitung von Beugungsdiagrammen aus einer Einrichtung mit einem fokussierten Partikelstrahl, wobei die Beugungsdiagramme jeweils von einem Partikel-Photonen-Umwandlungsschirm (1) erzeugt werden, welcher gegenüber Partikeln empfindlich ist, die durch einen von der Vorrichtung zu analysierenden Werkstoff für eine Position eines Primärpartikelstrahls auf der Oberfläche des Werkstoffs gebeugt werden,
**dadurch gekennzeichnet, dass** es außerdem umfasst:
- eine selektive Übertragung des Lichts, das anhand eines räumlichen Lichtmodulators (20) von dem Umwandlungsschirm (1) aus in wenigstens einem ausgewählten Bereich zu einem Fotodetektor (7) hin ausgesendet wird, wobei das Licht eine Photonenintensität aufweist, die die Beugungsmerkmale des Werkstoffs in dem ausgewählten Bereich wiedergibt,
- eine Erkennung einer Photonenintensität anhand des Fotodetektors (7), wobei jene Photonenintensität das durch den räumlichen Lichtmodulator (20) übertragene Licht wiedergibt, und
- eine Programmierung des räumlichen Lichtmodulators (20) nach einem Filterdiagramm (DF), um eine räumliche Filterfunktion des aus dem Umwandlungsschirm (1) erzeugten Lichts auszuführen.

2. Das Verfahren nach Anspruch 1, welches die Programmierung eines Filterdiagramms (DF) umfasst, wobei ein Bereich des Umwandlungsschirms (1) ausgewählt wird.

3. Das Verfahren nach Anspruch 1, welches die Programmierung eines Filterdiagramms (DF) umfasst, das einem Referenzbeugungsdiagramm entspricht.

4. Das Verfahren nach Anspruch 3, welches außerdem eine Erfassung eines Referenzbeugungsdiagramms für eine Position eines Primärpartikelstrahls auf der Oberfläche des Werkstoffs mit einer Sequenzprogrammierung einer Vielzahl von Filterdiagrammen (DF) umfasst, welche jeweils einem Bereich des Umwandlungsschirms (1) entsprechen, sodass die Photonenintensitäten sequentiell erfasst werden, die den verschiedenen Bereichen des Referenzbeugungsdiagramms entsprechen.

5. Das Verfahren nach einem der vorhergehenden Ansprüche, welches außerdem umfasst:
- ein Abtasten des Werkstoffs durch den Primärstrahl, sodass auf dem Umwandlungsschirm (1) eine Anordnung von Beugungsdiagrammen erstellt wird, welche als Individuum-Diagrammen (DI) bezeichnet werden und jeweils Abtastpunkten des Primärstrahls entsprechen, und
- für jeden Abtastpunkt eine Erzeugung eines der erkannten Photonenintensität entsprechenden Signals, dessen Höhe von dem Korrelationsgrad zwischen dem programmierten Filterdiagramm (DF) und dem dem Abtastpunkt entsprechenden Individuum-Diagramm (DI) abhängt.

6. Das Verfahren nach Anspruch 5, welches außerdem eine Erstellung, von den erzeugten Signalen ausgehend, eines Bildes (63), das eine räumliche Kartographie der kristallographischen Ausrichtung des Werkstoffs wiedergibt.

7. Das Verfahren nach einem der vorhergehenden Ansprüche, das in einer der folgenden Konfigurationen eingesetzt wird:
- mit einem Partikel-Photonen-Umwandler, gegenüber einem Probestück des zu analysierenden Werkstoffs angeordnet, sodass es sich bei den abgefangenen Partikeln um diejenigen handelt, die von dem Probestück zurückgestrahlt werden;
- mit einem Partikel-Photonen-Umwandler, hinter einem Probestück des zu analysierenden Werkstoffs angeordnet, sodass es sich bei den abgefangenen Partikeln um diejenigen handelt, die durch das Probestück hindurch gesendet werden.

8. Vorrichtung (10) zur Verarbeitung von Beugungsdiagrammen aus einer Einrichtung mit einem fokussierten Partikelstrahl, wobei die Beugungsdiagramme jeweils von einem Partikel-Photonen-Umwandlungsschirm (1) erzeugt werden, welcher gegenüber Partikeln empfindlich ist, die durch einen von der Einrichtung zu analysierenden Werkstoff für eine Position eines Primärpartikelstrahls auf der Oberfläche des Werkstoffs gebeugt werden, **dadurch gekennzeichnet, dass** sie umfasst:
- einen räumlichen Lichtmodulator (20), zur selektiven Übertragung des von dem Umwandlungsschirm (1) aus in wenigstens einem ausgewählten Bereich gesendeten Lichts auf einen Fotodetektor (7) geeignet, wobei das Licht eine Photonenintensität aufweist, die die Beugungsmerkmale des Werkstoffs in dem ausgewählten Bereich wiedergibt,
- einen Fotodetektor (7), zur Erkennung einer Photonenintensität geeignet, die das durch den räumlichen Lichtmodulator (20) übertragene Licht wiedergibt,
- Mittel zur Programmierung des räumlichen Lichtmodulators (20) nach einem Filterdiagramm (DF), um eine räumliche Filterfunktion des aus dem Umwandlungsschirm (1) erzeugten Lichts auszuführen.

9. Die Vorrichtung nach Anspruch 8, welche einen räumlichen Lichtmodulator mit einer Festkörperzellen- oder Flüssigkristallenmatrix zur Blockierung oder Übertragung des Lichts in Abhängigkeit von einem Steuersignal umfasst.

10. Die Vorrichtung nach Anspruch 8, welche einen räumlichen Lichtmodulator (20) mit mindestens einem mit Abknickung adressierbaren Spiegel (22) derart umfasst, dass der Spiegel wenigstens in einem Übertragungswinkel zum Fotodetektor hin ausgerichtet werden kann.

11. Die Vorrichtung nach Anspruch 10, welche einen räumlichen Lichtmodulator (20) vom Typ bistabil umfasst, mit einer Matrix (22) an einzeln adressierbaren Spiegeln mit Abknickung einer Amplitude, die jeweils dem Übertragungswinkel zum Fotodetektor hin und seinem Gegenüber entspricht.

12. Die Vorrichtung nach einem der Ansprüche 10 oder 11, bei welcher der räumliche Lichtmodulator (20) außerdem ein Prisma (3) mit Total- oder Teilreflexion umfasst, das gegenüber des mindestens einen Spiegels (22) angeordnet und dazu ausgebildet ist, lediglich das Licht auf den Fotodetektor (7) zu übertragen, welches durch den mindestens einen adressierbaren, in Abhängigkeit von dem Übertragungswinkel ausgerichteten Spiegel (22) übertragen wird.

13. Die Vorrichtung nach einem der Ansprüche 10 bis 12, welches außerdem unterhalb von dem räumlichen Lichtmodulator (20) eine optische Vorrichtung zur Photonenkonzentration (4) umfasst, welche für den Empfang der gespiegelten Strahlen aus dem räumlichen Modulator nach dem Übertragungswinkel angeordnet ist.

14. Die Vorrichtung nach Anspruch 13, welche außerdem unterhalb von der Vorrichtung zur Photonenkonzentration einen Lichttunnel (6) umfasst.

15. Die Vorrichtung nach einem der Ansprüche 8 bis 14, welche außerdem Mittel zum Abtasten des Werkstoffs mit dem Primärstrahl derart umfasst, dass auf dem Umwandlungsschirm (1) eine Anordnung von Beugungsdiagrammen erstellt wird, welche als Individuum-Diagramme (DI) bezeichnet werden und jeweils Abtastpunkten des Primärstrahls entsprechen.

16. Die Vorrichtung nach dem Anspruch 15, welche außerdem Mittel zur Erstellung eines Bildes (63) anhand der Signale aus dem Fotodetektor (7) und den Abtastpunkten des Primärstrahls entsprechend umfasst, wobei das Bild (63) eine räumliche Kartographie der kristallographischen Ausrichtung des Werkstoffs wiedergibt.

17. Die Vorrichtung nach einem der Ansprüche 8 bis 16, welche mit einem der folgenden Einrichtungen gekoppelt ist:
- einer Einrichtung zur Rasterelektronenmikroskopie im Rückstreuungsmodus,
- einer Einrichtung zur Rasterelektronenmikroskopie im Übertragungsmodus,
- einer Einrichtung zur Erzeugung von fokussierten Elektronen,
- einer Einrichtung zur Erzeugung von fokussierten Ionen.

18. Analytisches Bildgebungssystem, umfassend eine Einrichtung mit einem fokussierten Partikelstrahl mit einer Vorrichtung zur Verarbeitung von Beugungsdiagrammen nach einem der Ansprüche 8 bis 17.

## Claims

1. Method for processing diffraction patterns originating from a piece of equipment utilizing a focused particle beam, these diffraction patterns being generated respectively by a particle-photon converter screen (1) sensitive to particles diffracted by a material to be analysed by said equipment, for a position of a primary particle beam on the surface of said material, **characterized in that** it comprises:
- selectively transmitting to a photodetector (7), by means of a spatial light modulator (20), light emitted from said converter screen (1) in at least one selected zone, this light having a photonic intensity representative of the diffraction characteristics of the material in said selected zone,
- detecting, by means of said photodetector (7), a photonic intensity representative of the light transmitted by said spatial light modulator (20), and
- programming said spatial light modulator (20) according to a filter pattern (DF) to produce a spatial filtering function for the light originating from said converter screen (1).

2. The method of claim 1, which comprises programming a filter pattern (DF) corresponding to a selection of a zone of the converter screen (1).

3. The method of claim 1, which comprises programming a filter pattern (DF) corresponding to a reference diffraction pattern.

4. The method of claim 3, which also comprises acquiring a reference diffraction pattern for a position of a primary particle beam on the surface of the material, with a sequential programming of a plurality of filter patterns (DF) each corresponding to a zone of the converter screen (1), so as to sequentially detect the photonic intensities corresponding to the different zones of said reference diffraction pattern.

5. The method of one of the preceding claims, which also comprises:
- scanning the material with the primary beam so as to produce, on the converter screen (1), a set of diffraction patterns, called Individual Patterns (DI), corresponding respectively to scanning points of said primary beam and,
- for each scanning point, generating a signal corresponding to the photonic intensity detected, the level of which is a function of the degree of correlation between the programmed filter pattern (DF) and the Individual Pattern (DI) corresponding to said scanning point.

6. The method of claim 5, which also comprises producing, from the signals generated, an image (63) constituting a spatial mapping of the crystallographic orientation of the material.

7. The method of any one of the preceding claims, which is implemented in any one of the following configurations:
- with a particle-photon converter located facing a sample of material to be analysed so that the intercepted particles are those backscattered by said sample;
- with a particle-photon converter located behind a sample of material to be analysed so that the intercepted particles are those transmitted through said sample.

8. Device (10) for processing diffraction patterns originating from a piece of equipment utilizing a focused particle beam, these diffraction patterns being respectively generated by a particle-photon converter screen (1) sensitive to particles diffracted by a material to be analysed by said equipment for a position of a primary particle beam on the surface of said material, **characterized in that** it comprises:
- a spatial light modulator (20), capable of selectively transmitting to a photodetector (7) the light emitted from said converter screen (1) in at least one selected zone, this light having a photonic intensity representative of the diffraction characteristics of the material in said selected zone,
- a photodetector (7) capable of detecting a photonic intensity representative of the light transmitted by said spatial light modulator (20),
- means of programming said spatial light modulator (20) according to a filter pattern (DF) to produce a spatial filtering function for the light originating from said converter screen (1).

9. The device of claim 8, which comprises a spatial light modulator with an array of solid cells or liquid crystal cells capable of blocking or transmitting the light as a function of a control signal.

10. **The** device of claim 8, which comprises a spatial light modulator (20) with at least one angular deviation steering mirror (22), so as to be able to be oriented at least according to an angle of transmission to the photodetector.

11. The device of claim 10, which comprises a spatial light modulator (20) of the bistable type, with an array (22) of mirrors which are individually steerable in terms of angular deviation with an amplitude corresponding respectively to the transmission angle to the photodetector and its opposite.

12. The device of one of claims 10 or 11, in which the spatial light modulator (20) also comprises a prism (3) with total or partial reflection arranged facing the mirror or mirrors (22) and arranged so as to transmit to the photodetector (7) solely the light sent back by the steering mirror or mirrors (22) oriented according to the transmission angle.

13. The device of one of claims 10 to 12, which also comprises, downstream of the spatial light modulator (20), an optical device for concentrating photons (4) arranged to receive the reflected rays originating from said spatial modulator according to the transmission angle.

14. The device of claim 13, which also comprises, downstream of the device for concentrating photons, a light tunnel (6).

15. The device of one of claims 8 to 14, which also comprises means for scanning the material with the primary beam so as to produce on the converter screen (1) a set of diffraction patterns, called Individual Patterns (DI), corresponding respectively to scanning points of said primary beam.

16. The device of claim 15, which also comprises means for producing, from the signals originating from the photodetector (7) and corresponding to the scanning points of the primary beam, an image (63) constituting a spatial mapping of the crystallographic orientation of the material.

17. The device of any one of claims 8 to 16, which is coupled to one of the following items of equipment:
- scanning electron microscopy equipment in backscattering mode,
- scanning electron microscopy equipment in transmission mode,
- equipment for generating focused electrons,
- equipment for generating focused ions.

18. Analytical imaging system comprising a piece of equipment utilizing a focused particle beam equipped with a device for processing diffraction patterns according to any one of claims 8 to 17.
